# EUROPEAN PATENT SPECIFICATION

(11) **EP 1 865 597 B1**
(45) Date of publication and mention of the grant of the patent: **03.08.2011**
(21) Application number: 06730039.2
(22) Date of filing: 27.03.2006
(51) Int. Cl.: H03F 3/217, H03F 1/30, H03F 1/32

(54) **AMPLIFIER APPARATUS**
VERSTÄRKERVORRICHTUNG
APPAREIL AMPLIFICATEUR

(30) Priority: 28.03.2005 JP 2005091892
(43) Date of publication of application: 12.12.2007
(73) Proprietor: NEC Corporation, Minato-ku Tokyo 108-8001 (JP)
(72) Inventor: SASAKI, Yutaka c/o NEC Saitama, Ltd.,, Saitama 3670297 (JP)
(74) Representative: Heunemann, Dieter
(86) International application number: PCT/JP2006/306091
(87) International publication number: WO 2006/104075

(56) References cited:
- WO-A-2004/015855
- JP-A- 09 148 851
- JP-A- 2004 356 963
- JP-A- 2005 012 868
- US-A- 5 510 753
- US-A1- 2005 122 162
- US-B2- 6 831 509
- TRANSISTOR GIJUTSU vol. 40, no. 8, 01 August 2003, pages 132 - 139, XP003005277

## Description

### TECHNICAL FIELD

The present invention relates to an amplifier used for a portable device etc.

### BACKGROUND ART

In a portable device etc. using a battery, a step-up DC-DC converter is increasingly used as a power supply circuit, in order to secure a large sound. In this situation, it is required to secure a higher sound quality and the large sound volume at the same time.

Conventionally, in the portable device using a battery, a variety of amplifiers are proposed which employ a D-class amplifier for amplifying an audio signal and a DC-DC converter in the power supply circuit to step up the battery voltage configuring the power source (refer to Patent Publication JP-1989-147907, for example).

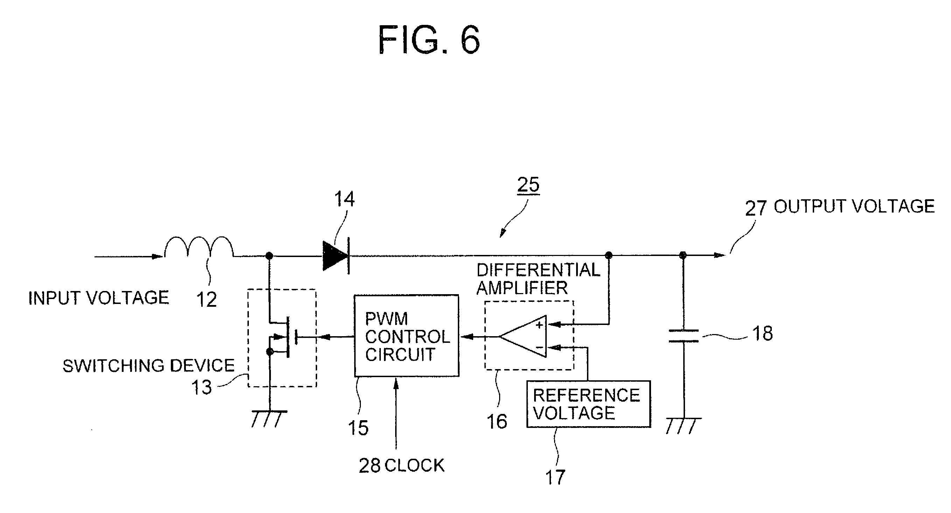

Hereinafter, a conventional step-up DC-DC converter will be described with reference to Fig. 6.
As shown in the figure, the conventional step-up DC-DC converter 25 compares the output voltage 27 of the DC-DC converter against a reference voltage 17, and controls a switching device 13 via a differential amplifier 16 and using a PWM (pulse width modulation) control circuit 15 so that the difference approaches "zero".

In such a step-up DC-DC converter 25, neglecting the loss of the devices used therein, the relationship Vout=(1+Ton/Toff)xVin holds where Vin, Vout, Ton, and Toff represent the input voltage, output voltage, ON time of the switching device 13 and OFF time thereof, respectively. The output voltage 18 can be smoothed using a capacitor 18 to reduce the ripples generated therein by the switching to some extent, and thus Vout may be expressed as the average voltage.

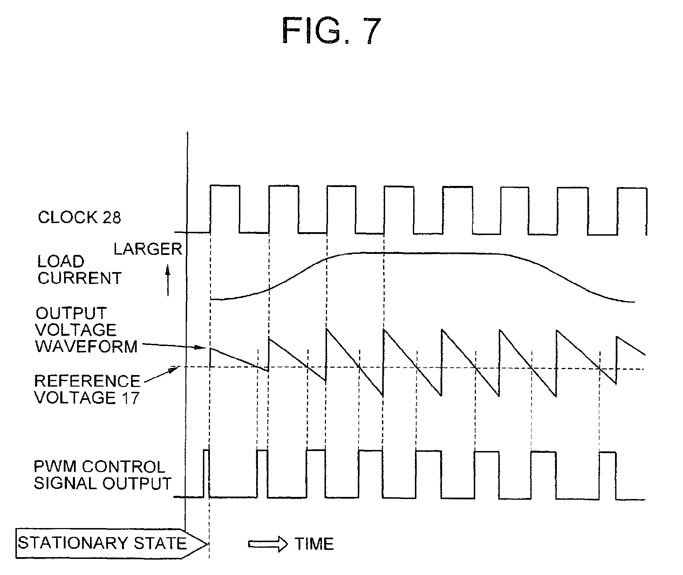

FIG. 7 shows a time chart of the operation. In FIG. 7, the time advances from the left-hand side toward the right-hand side and a stationary state of the DC-DC converter 25 is shown at the left-hand side.

In a time zone of the stationary state of the DC-DC converter 25 of Fig. 6, the output voltage 27 of the DC-DC converter 25 is compared against the reference voltage 17 in the differential amplifier 16, and the PWM control circuit 15 synchronized with a clock signal 28, which is input separately, controls the switching device 13 so that the difference therebetween assumes "zero".

In the time chart of Fig. 7, when the output voltage 27 becomes lower than the reference voltage 17, the PWM signal assumes positive, whereby the switching device 13 is turned ON. At the next rising edge of the clock, the PWM signal assumes negative by a reset. Since the switching device 13 is turned OFF at the instance when the PWM signal assumes negative, the energy stored in an inductor 12 is released so that the current flows in an opposite direction, and appears as an output voltage across a rectifying element 14. For this reason, the waveform of the output voltage assumes a high voltage at the rising edge of the clock, and gradually reduces until occurring of the next clock, whereby this waveform is defined as the ripples of the output voltage. Since the capacitor 18 is coupled to the output voltage 27, the change thereof is generally moderate.

If the load current of the DC-DC converter 25 increases, the output voltage 27 experiences a rapid voltage fall until the next clock, as a result of which the average of the output voltage 27 reduces so long as the ratio of Ton to Toff is constant. The PWM system uses a control technique such that the voltage fall is suppressed by comparing the reduced voltage and the reference voltage 17 against each other in the differential amplifier to change the time ratio of Ton to Toff. That is, in the PWM system, a larger ratio of Ton to Toff, if employed, results in a larger pulse width, which raises the output voltage 27.

Conversely, if the load current reduces, the output voltage 27 experiences a moderate voltage fall until the next clock, which reduces the pulse width. However, if the load current rapidly changes, the output voltage 27 may temporarily fall in the case of an increased current, due to occurring of a delay time, such as a time length needed for the differential amplifier 16 to detect the voltage drop and a time length need therefrom to control the switching device 13. In the case of a rapid decrease of the load current, the output voltage 27 may temporarily rise.
Other related art is found in US5510753, US6831509, WO 2004/015855, JP9148851, for example.

### DISCLOSURE OF THE INVENTION

### Problems to be Solved by the Invention

As described heretofore, use of the power supply circuit including the conventional DC-DC converter incurs, upon a rapid level change of the input signal of the D-class amplifier, a temporary fall in the output voltage of the DC-DC converter. This is because the time delay occurs from the time instant when the differential amplifier 16 of the DC-DC converter 25 detects the voltage fall and the time instant when the PWM control circuit 15 changes the pulse width, and the output voltage of the power supply source becomes unstable during the delay time and the transient response time. In the case of a D-class amplifier in particular, the temporary fall of the output voltage of the power supply source causes the output thereof to have a large distortion, and if the speaker suddenly outputs a larger volume, the beginning portion of the loud sound thus output has an increased distortion to generate a noisy sound, to cause a problem.

It is an object of the present invention to provide an amplifier wherein the PWM signal of the amplifying block driving a speaker is made as the PWM signal for the power supply source, to increase the output capacitance of the power supply source at the same timing at which the amplifying block outputs a loud volume, whereby the fluctuation of the output voltage of the power supply source is reduced to reduce distortion of the sound at the rising edge thereof.

### Means for Solving the Problem

The present invention provides an amplifier including an amplifying block for receiving an input signal to drive a speaker and a power supply block for supplying an output voltage to the amplifying block, wherein: the amplifying block includes a PWM-signal generation circuit for converting the input signal to a PWM signal, a speaker driving circuit for driving the speaker based on the PWM signal, a differential amplifier receiving the input signal and a feedback signal from the speaker and driving the PWM-Signal generation circuit, and a duty detection circuit for outputting a pulse width signal depending on a pulse width of the PWM signal; and the power supply block includes a PWM control circuit for controlling the output voltage based on the pulse width signal.

### [Effect of the Invention]

According to the amplifier of the present invention, control of the output voltage of the power supply block by the PWM control circuit of the power supply block based on the pulse width signal, which depends on the pulse width of the PWM signal of the amplifying block driving the speaker, allows the output voltage of the power supply block to be higher at the same timing when the amplifying block outputs a larger sound. For this reason, fluctuation of the power supply voltage may be made small to reduce the distortion of the sound at the rise timing thereof. It is preferable to adopt, as the above pulse width signal, a signal depending on the difference between the pulse width of the PWM pulse and the interval between each pulse and an adjacent pulse, or a signal depending on the duty ratio which is a ratio of the pulse width to the pulse interval. The depending signal may preferably be a signal monotonically increasing with an increase of the pulse width that the pulse width signal represents, and may be a proportional signal, for example.

### BRIEF DESCRIPTION OF THE DRAWINGS

FIG. 1 is a block diagram of an amplifier according to a first embodiment.
FIG. 2 is a time chart showing the output operation of the PWM-signal generation circuit of the D-class amplifier in the same.
FIG. 3 is a time chart showing the output operation of the low-pass-filter of the D-class amplifier in the same.
FIG. 4 is a similar time chart of the duty detection circuit in the same.
FIG. 5 is a block diagram of an amplifier according to a second embodiment.
FIG. 6 is a block diagram of a DC-DC converter configuring a power source block of a conventional amplifier.
FIG. 7 is a time chart showing the operation of the DC-DC converter of Fig. 6.

### BEST MODE FOR CARRYING OUT THE INVENTION

Hereinafter, embodiments of the present invention will be described with reference to the drawings.

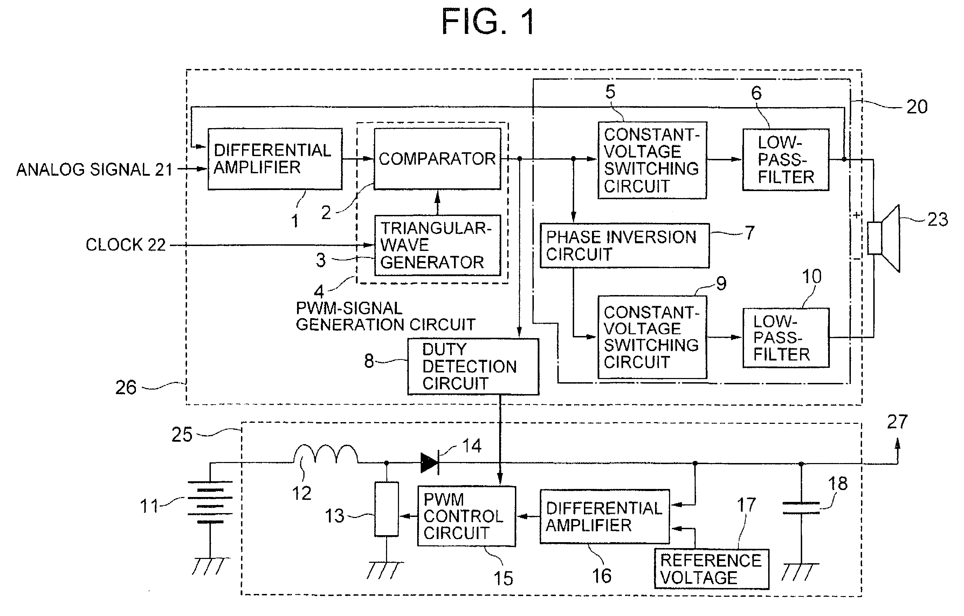

Fig. 1 is a block diagram showing a first embodiment of the amplifier according to the present invention.

The present invention is directed to an amplifier including amplifying block 26 which receives an input signal to drive a speaker, and a power supply block 25 which supplies power supply voltage to the amplifying block 26, wherein the amplifying block 26 includes a PWM-signal generation circuit 4 which converts the input signal into a PWM signal, and a duty detection circuit 8 which outputs a signal proportional to a time difference component of the PWM signal, and the power supply block 25 includes a PWM control circuit 15 which receives a signal from the duty detection circuit 8 to control the power supply output voltage based on the received signal.

In the amplifier of the present embodiment, as shown in Fig. 1, a D-class amplifier 26 of a PWM scheme is used as the amplifying block which drives the speaker 23. An analog signal 21, as an input of the D-class amplifier 26, is input to the differential amplifier 1, and the signal input to the speaker 23 is also input to the differential amplifier 1 for a feedback control. The output signal of the differential amplifier 1 is input to a comparator 2 for comparison against a triangular wave in a comparator 2 which outputs a PWM signal, the triangular wave being generated in a triangular-wave generation circuit 3 based on a clock signal 22 separately input thereto. More specifically, the comparator 2 and triangular-wave generation circuit (triangular wave generator 3) configure the PMW signal generation circuit 4.

The PWM signal output from the comparator 2 drives the constant-voltage switching circuits 5,9 and is also input to the duty detection circuit 8, which outputs a signal proportional to the difference between the ON-time (Ton) and the OFF-time (Toff), whereby the PWM signal is converted into a signal which is in proportion to the time difference. The output signal from the duty detection circuit 8 is used as an input signal of the of PMW control circuit 15 of the DC-DC converter 25 which configures the power supply block supplying the power source to the D-class amplifier 26, and controls the output voltage of the DC-DC converter 25.

The present embodiment uses the D-class amplifier 26 of the PWM scheme having a full-bridge connection generally used, and the PWM signal for driving the constant-voltage switching circuit 5 is supplied through two branches. One of the branched signals is passed by a phase inversion circuit 7 for phase inversion thereof, to drive the constant-voltage switching circuit 9, whereby the constant-voltage switching circuits 5 and 9 have opposite phases. The output of each of the constant-voltage switching circuits 5, 9 is coupled to a low-pass-filter 6, 10, which removes therefrom noise such as a clock component, and drives the speaker 23.

A step-up DC-DC converter 25 of the PWM drive scheme is used as the power supply block which supplies power source to the D-class amplifier 26.

The power supply voltage supplied from a battery 11 is supplied to a switching device 13 via an inductor 12. The PWM signal generated in the D-class amplifier 26 is converted, in the duty detection circuit 8, into a signal which is proportional to the time difference between Ton and Toff, and drives the switching device 13 via the PWM control circuit 15. Since the voltage output from the rectifying element 14 connected to the output side of the inductor 12 includes ripples, a capacitor 18 is used to output a smooth output voltage 27.

In the way as described above, the DC-DC converter 25 configuring the power supply block is driven by the signal directly linked with the level of the input signal of the D-class amplifier 26 which drives the speaker 23, whereby the DC-DC converter 25 can rise rapidly. Thus, the DC-DC converter 25 can suppress the drop of the power supply voltage in the case of a rapid increase in the load current.

Hereinafter, operation of the above amplifier will be described in more detail. Operation of the circuit of the D-class amplifier 26 configuring the amplifying block will be described first.

The input analog signal 21 is input to the differential amplifier 1, which delivers a difference between the analog signal 21 and the feedback control signal to the PWM-signal generation circuit 4. This feedback control exerts control of the gain of the entire amplifier circuit, and reduction in the distortion occurring.

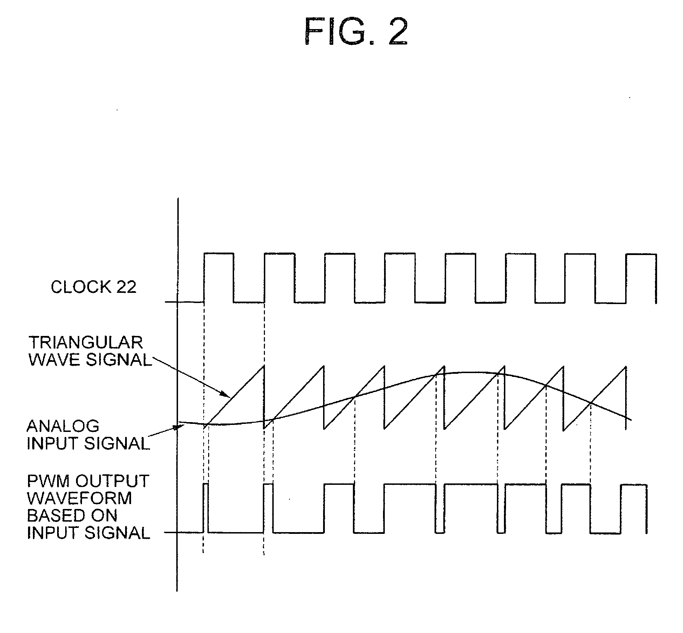

The PWM-signal generation circuit 4 is comprised of the comparator 2 and triangular-wave generation circuit 3, and outputs the PWM signal as in the time chart shown in FIG. 2. More specifically, the analog input signal which is the output signal of the differential amplifier 1 is compared against the level of the triangular wave signal which is the output signal of the triangular-wave generation circuit 3 with reference to the clock 22.

If the analog input signal is higher than the triangular wave signal, the output of the comparator 2 assumes a "positive" signal; and if the analog input signal is lower than the triangular wave signal, the output of the comparator assumes a "negative" signal. This signal is the PWM signal which has a pulse width proportional to the voltage of the analog input signal. The clock 22 is a sampling clock having a sufficiently higher frequency compared to the maximum frequency of the analog input signal. The triangular-wave generation circuit 3 generates the triangular wave signal based on this clock.

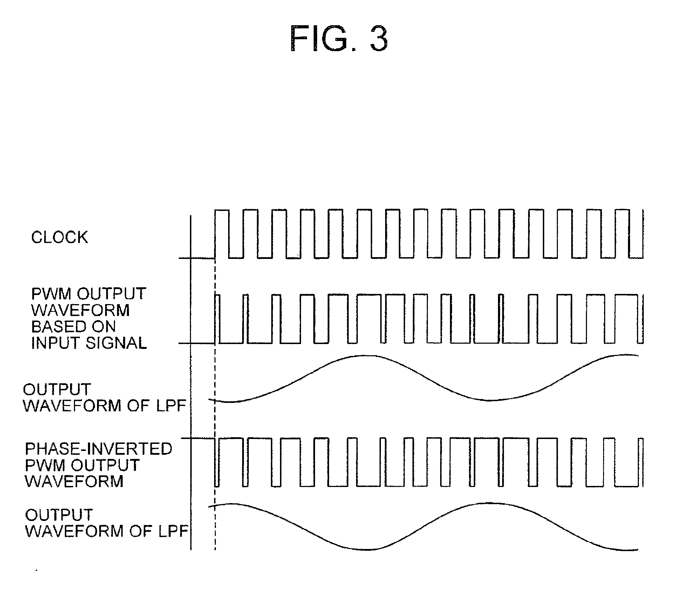

The PWM signal output from the PWM-signal generation circuit 4 is separated into two: one passing through the phase inversion circuit 7 which generates a signal having a phase shift of 180 degrees; and the other not passing through such a phase inversion circuit. The two signals are passed by the constant-voltage switching circuits 5, 9 and low-pass-filters 6, 10 to be again converted into the analog signals, which drive the speaker in opposite phases. FIG. 3 shows this operation in a time chart.

In FIG. 3, the PWM signal obtained with reference to the clock 22 is input to the constant-voltage switching circuit 5, provided with electric power sufficient to drive the speaker 23, and subjected to removal of the clock component therefrom in the low-pass-filter 6, whereby this PWM signal has an analog voltage level which is proportional to the duration of the pulse width, and assumes an analog signal having a level proportional to the input signal 21. The PWM signal subjected to the phase inversion is input to the constant-voltage switching circuit 9, provided with electric power sufficient to drive the speaker 23, and subjected to removal of the clock component therefrom in the low-pass-filter 10, whereby this PWM signal assumes an analog signal having a level proportional to the input signal and has a phase opposite thereto.

This driving scheme of the speaker 23 is generally adopted as a full-bridge-connection system, and has a variety of advantages of expected higher output power under a lower power supply voltage, a higher utilization factor of the power supply source, and omission of the output coupling capacitor. However, as the driving scheme of the speaker, a half-bridge connection system including a single constant-voltage switching circuit may be adopted other than the full-bridge connection system.

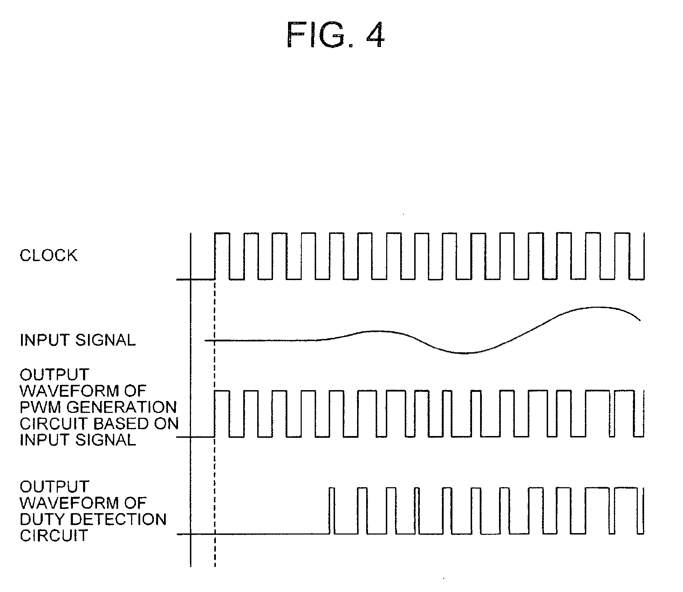

On the other hand, the PWM signal output from the PWM-signal generation circuit 4 is further delivered to the duty detection circuit 8. In this circuit, as shown in the time chart shown in FIG. 4, the signal which is proportional to the time difference between Ton and Toff of the PWM signal output from the PWM-signal generation circuit 4 is output within a time interval between the rising edge and the next rising edge of the clock. In fact, it is generally necessary to introduce a coefficient to this signal, and to adjust the DC-DC converter to output a suitable voltage as the power supply voltage when the speaker has a loud sound.

Next, the DC-DC converter 25 configuring the power supply block will be described.
In the step-up DC-DC converter shown in FIG. 1, the input voltage from the battery 11 is coupled to the switching device 13 and rectifying element 14 via the inductor 12, and the switching device 13 couples one of the terminals of the inductor 12 to the ground level during a controlled time length (Ton) via the control of the PWM control circuit 15, whereby the DC-DC converter 25 outputs the voltage proportional to Ton and Toff of the switching device 13 in response to the input voltage from the battery 11. The voltage thus output is smoothed by the capacitor 18 to be subjected to removal of the ripples therefrom, and is thus controlled to have a substantially constant average voltage.

If the switching device 13 is controlled by the PWM signal output from the D-class amplifier 26 at this stage, upon an increase of the load current of the DC-DC converter 25, i.e., upon an increase of the dissipation current due to a loud sound output from the D-class amplifier 26, the pulse width of the signal output from the duty detection circuit 8 based on the PWM signal changes from the beginning, whereby a reduction in the power source voltage output from the DC-DC converter 25 can be suppressed.

A technique is generally adopted wherein the DC-DC converter 25 is fixed at the state of a lower duty in the case of an extremely lower load current, and automatically changed into the PFM control scheme where the control clock frequency is variable to prevent a reduction in the efficiency of the DC-DC converter 25. It is to be noted that the PFM control system refers to a control technique of pulse frequency modulation, wherein the frequency is changed without changing the duty of the pulses.

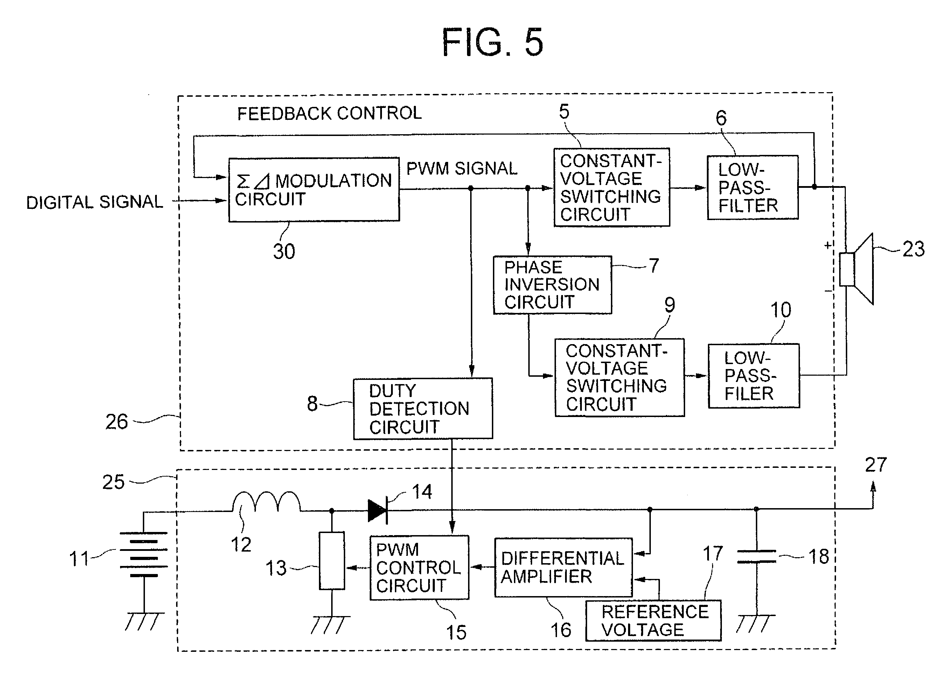

Fig. 5 shows a second embodiment of the present invention.
Although an analog signal is input in the embodiment shown in Fig. 1, input of a digital signal may be used as it is, so long as the digital signal is converted into the PWM signal. Fig. 5 exemplifies use of ΣΔ modulation circuit 30 as the D-class amplifier 26 to generate the PWM signal. If the digital signal includes a plurality of bits, the digital signal may be used as it is so long as the duty detection circuit 8 converts the difference therein into the PWM signal. Any of the digital signal and analog signal may be used as the input signal therein.

The amplifier of the present embodiment may be applied in any of the portable devices, such as a cellular phone, PHS and PDA, which uses a D-class amplifier 26 to drive a speaker 23 and has a function of outputting audio from the speaker, and in which the voltage of the battery 11 is stepped-up by the DC-DC converter 25 to obtain the power source.

While the invention has been described with reference to preferred embodiments thereof, the amplifier of the present invention is not limited only to the configuration of the embodiments, and various changes or alterations made to the configuration of the above embodiments may fall within the scope of the present invention. For example, although the signal proportional to the time difference signal of the PWM signal is used in the above embodiments, the present invention is not limited thereto, and the duty ratio of the PWM pulse, besides the time difference signal of the PWM pulse, may be used as the pulse width signal, and not limited to a proportional signal so long as the signal monotonically increases with an increase in the pulse width of the PWM pulses.

## Claims

1. An amplifier comprising an amplifying block (26) for receiving an input signal (21) to drive a speaker (23) and a power supply block (25) for supplying an output voltage to said amplifying block, wherein:
said amplifying block (26) comprises a PWM-signal generation circuit (4) for converting said input signal (21) into a PWM signal, a speaker driving circuit (20) for driving said speaker based on said PWM signal, a differential amplifier (1) for receiving said input signal (21) and a signal to be outputted from the speaker driving circuit (20) to the speaker (23) for a feedback control, and delivering a difference between said two signals to the PWM-Signal generation circuit (4) and a duty detection circuit (8) for outputting a pulse width signal depending on a pulse width of said PWM signal; and
said power supply block (25) comprises a PWM control circuit (15) for controlling the output voltage based on said pulse width signal.

2. An amplifier comprising an amplifying block (26) for receiving an input signal to drive a speaker (23) and a power supply block (25) for supplying an output voltage to said amplifying block, wherein:
said amplifying block (26) comprises a PWM-signal generation circuit (30) which is a Σ,Δ modulation unit for converting said input signal into a PWM signal, a speaker driving circuit (20) for driving said speaker based on said PWM signal, and a duty detection circuit (8) for outputting a pulse width signal depending on a pulse width of said PWM signal wherein the Σ,Δ modulation circuit (30) is adapted to receive said input signal and a signal to be outputted from the speaker driving circuit (20) to the speaker (23) for a feedback control , and
said power supply block (25) comprises a PWM control circuit (15) for controlling the output voltage based on said pulse width signal.

3. The amplifier according to claim 1 or 2, wherein said speaker driving circuit (20) comprises a first switching circuit for receiving said PWM signal, a first filter (6) for delivering an output of said first switching circuit, after removing a specific frequency component therefrom, to one of terminals of said speaker, a phase inversion circuit (7) for inverting the phase of said PWM signal, a second switching circuit for receiving an output of said phase inversion circuit, and a second filter (10) delivering an output of said second switching circuit to the other of the terminals of said speaker after removing a specific frequency component therefrom.

4. The amplifier according to claim 1 or 2, wherein said speaker driving circuit (20) includes a switching circuit for receiving said PWM signal, and a filter (6) for delivering an output of said switching circuit to said speaker, after removing a specific frequency component therefrom, and said speaker is connected in a half-bridge connection.

5. The amplifier according to claim 1 or 2, wherein said amplifying block (26) is a D-class amplifier.

6. The amplifier according to claim 1 or 2, wherein said power supply block (25) is a DC-DC converter, the DC-DC converter (25) includes a differential amplifier (16) for comparing said output voltage and a reference voltage to amplify a difference therebetween, and said PWM control circuit (15) controls ON/OFF of a switching device (13) based on an output of said differential amplifier (16).

## Patentansprüche

1. Verstärker mit einem Verstärkungsblock (26) zum Empfangen eines Eingangssignals (21) zum Ansteuern eines Lautsprechers (23) und mit einem Stromversorgungsblock (25) zum Zuführen einer Ausgangsspannung zum Verstärkungsblock, wobei:
der Verstärkungsblock (26) aufweist: eine PWM-Signalerzeugungsschaltung (4) zum Umwandeln des Eingangssignals (21) in ein PWM-Signal, eine Lautsprechertreiberschaltung (20) zum Ansteuern des Lautsprechers basierend auf dem PWM-Signal, einen Differenzverstärker (1) zum Empfangen des Eingangssignals (21) und eines von der Lautsprechertreiberschaltung (20) an den Lautsprecher (23) auszugebenden Signals für eine Rückkopplungssteuerung und zum Zuführen einer Differenz zwischen den beiden Signalen an die PWM-Signalerzeugungsschaltung (4) und eine Tastverhältnis-Erfassungsschaltung (8) zum Ausgeben eines Pulsbreitensignals in Abhängigkeit von einer Pulsbreite des PWM-Signals; und
der Stromversorgungsblock (25) eine PWM-Steuerschaltung (15) zum Steuern der Ausgangsspannung basierend auf dem Pulsbreitensignal aufweist.

2. Verstärker mit einem Verstärkungsblock (26) zum Empfangen eines Eingangssignals (21) zum Ansteuern eines Lautsprechers (23) und mit einem Stromversorgungsblock (25) zum Zuführen einer Ausgangsspannung zum Verstärkungsblock, wobei:
der Verstärkungsblock (26) aufweist: eine als eine ΣΔ-Modulationsschaltung konfigurierte PWM-Signalerzeugungsschaltung (30) zum Umwandeln des Eingangssignals (21) in ein PWM-Signal, eine Lautsprechertreiberschaltung (20) zum Ansteuern des Lautsprechers basierend auf dem PWM-Signal und eine Tastverhältnis-Differenz-Erfassungsschaltung (8) zum Ausgeben eines Pulsbreitensignals in Abhängigkeit von einer Pulsbreite des PWM-Signals, wobei die ΣΔ-Modulationsschaltung (30) dazu geeignet ist, das Eingangssignal und ein von der Lautsprechertreiberschaltung (20) an den Lautsprecher (23) auszugebenes Signal für eine Rückkopplungssteuerung zu empfangen; und
der Stromversorgungsblock (25) eine PWM-Steuerschaltung (15) zum Steuern der Ausgangsspannung basierend auf dem Pulsbreitensignal aufweist.

3. Verstärker nach Anspruch 1 oder 2, wobei die Lautsprechertreiberschaltung (20) aufweist: eine erste Schaltschaltung zum Empfangen des PWM-Signals, ein erstes Filter (6) zum Zuführen eines Ausgangssignals der ersten Schaltschaltung zu einem der Anschlüsse des Lautsprechers, nachdem eine spezifische Frequenzkomponente davon entfernt worden ist, eine Phaseninvertierungsschaltung (7) zum Invertieren der Phase des PWM-Signals, eine zweite Schaltschaltung zum Empfangen eines Ausgangssignals der Phaseninvertierungsschaltung und ein zweites Filter (10) zum Zuführen eines Ausgangssignals der zweiten Schaltschaltung zu dem anderen der Anschlüsse des Lautsprechers, nachdem eine spezifische Frequenzkomponente davon entfernt worden ist.

4. Verstärker nach Anspruch 1 oder 2, wobei die Lautsprechertreiberschaltung (20) aufweist: eine Schaltschaltung zum Empfangen des PWM-Signals und ein Filter (6) zum Zuführen eines Ausgangssignals der Schaltschaltung zum Lautsprecher, nachdem eine spezifische Frequenzkomponente davon entfernt worden ist, und wobei der Lautsprecher in einer Halbbrückenschaltung geschaltet ist.

5. Verstärker nach Anspruch 1 oder 2, wobei der Verstärkungsblock (26) ein Klasse-D-Verstärker ist.

6. Verstärker nach Anspruch 1 oder 2, wobei der Spannungsversorgungsblock (25) ein DC-DC-Wandler ist, wobei der DC-DC-Wandler (25) einen Differenzverstärker (16) zum Vergleichen der Ausgangsspannung mit einer Referenzspannung zum Verstärken einer Differenz dazwischen aufweist, und wobei die PWM-Steuerschaltung (15) den Ein- /Aus-Zustand einer Schalteinrichtung (13) basierend auf einem Ausgangssignal des Differenzverstärkers (16) steuert.

## Revendications

1. Amplificateur comprenant un bloc d'amplification (26) pour recevoir un signal d'entrée (21) pour commander un haut-parleur (23) et un bloc d'alimentation (25) pour fournir une tension de sortie audit bloc d'amplification, dans lequel :
ledit bloc d'amplification (26) comprend un circuit de génération de signal de modulation de durée d'impulsion (4) pour convertir ledit signal d'entrée (21) en un signal de modulation de durée d'impulsion, un circuit de commande de haut-parleur (20) pour commander ledit haut-parleur sur la base dudit signal de modulation de durée d'impulsion, un amplificateur différentiel (1) pour recevoir ledit signal d'entrée (21) et un signal devant être délivré du circuit de commande de haut-parleur (20) au haut-parleur (23) pour une commande à rétroaction, et délivrer une différence entre lesdits deux signaux au circuit de génération de signal de modulation de durée d'impulsion (4), et un circuit de détection de rapport cyclique (8) pour délivrer un signal de durée d'impulsion en fonction d'une durée d'impulsion dudit signal de modulation de durée d'impulsion ; et
ledit bloc d'alimentation (25) comprend un circuit de commande de modulation de durée d'impulsion (15) pour commander la tension de sortie sur la base dudit signal de durée d'impulsion.

2. Amplificateur comprenant un bloc d'amplification (26) pour recevoir un signal d'entrée pour commander un haut-parleur (23) et un bloc d'alimentation (25) pour délivrer une tension de sortie audit bloc d'amplification, dans lequel :
ledit bloc d'amplification (26) comprend un circuit de génération de signal de modulation de durée d'impulsion (30) qui est une unité de modulation ΣΔ pour convertir ledit signal d'entrée en un signal de modulation de durée d'impulsion, un circuit de commande de haut-parleur (20) pour commander ledit haut-parleur sur la base dudit signal de modulation de durée d'impulsion, et un circuit de détection de rapport cyclique (8) pour délivrer un signal de durée d'impulsion en fonction d'une durée d'impulsion dudit signal de modulation de durée d'impulsion, dans lequel le circuit de modulation ΣΔ (30) est conçu pour recevoir ledit signal d'entrée et un signal à délivrer du circuit de commande de haut-parleur (20) au haut-parleur (23) pour une commande à rétroaction ; et
ledit bloc d'alimentation (25) comprend un circuit de commande de modulation de durée d'impulsion (15) pour commander la tension de sortie sur la base dudit signal de durée d'impulsion.

3. Amplificateur selon la revendication 1 ou 2, dans lequel ledit circuit de commande de haut-parleur (20) comprend un premier circuit de commutation pour recevoir ledit signal de modulation de durée d'impulsion, un premier filtre (6) pour délivrer une sortie dudit premier circuit de commutation, après le retrait d'une composante de fréquence spécifique de celle-ci, à l'une des bornes dudit haut-parleur, un circuit d'inversion de phase (7) pour inverser la phase dudit signal de modulation de durée d'impulsion, un deuxième circuit de commutation pour recevoir une sortie dudit circuit d'inversion de phase, et un deuxième filtre (10) délivrant une sortie dudit deuxième circuit de commutation à l'autre des bornes dudit haut-parleur après le retrait d'une composante de fréquence spécifique de celle-ci.

4. Amplificateur selon la revendication 1 ou 2, dans lequel ledit circuit de commande de haut-parleur (20) comprend un circuit de commutation pour recevoir ledit signal de modulation de durée d'impulsion, et un filtre (6) pour délivrer une sortie dudit circuit de commutation audit haut-parleur, après le retrait d'une composante de fréquence spécifique de celle-ci, et ledit haut-parleur est connecté en une connexion en demi-pont.

5. Amplificateur selon la revendication 1 ou 2, dans lequel ledit bloc d'amplification (26) est un amplificateur de classe D.

6. Amplificateur selon la revendication 1 ou 2, dans lequel ledit bloc d'alimentation (25) est un convertisseur continu-continu, le convertisseur continu-continu (25) comprend un amplificateur différentiel (16) pour comparer ladite tension de sortie et une tension de référence pour amplifier une différence entre celles-ci, et ledit circuit de commande de modulation de durée d'impulsion (15)
commande la fermeture/l'ouverture d'un dispositif de commutation (13) sur la base d'une sortie dudit amplificateur différentiel (16).
